# EUROPÄISCHE PATENTSCHRIFT

(11) **EP 2 201 419 B1**
(45) Veröffentlichungstag und Bekanntmachung des Hinweises auf die Patenterteilung: **07.12.2011**
(21) Anmeldenummer: 08775281.2
(22) Anmeldetag: 22.07.2008
(51) Int. Cl.: G02B 6/42, H01S 5/40, F02P 23/04

(54) **DIODENLASER MIT EINER EINRICHTUNG ZUR STRAHLFORMUNG**
DIODE LASER HAVING A DEVICE FOR BEAM FORMING
LASER À DIODES COMPRENANT UN DISPOSITIF DE MISE EN FORME DE FAISCEAU

(30) Priorität: 14.09.2007 DE 102007044011
(43) Veröffentlichungstag der Anmeldung: 30.06.2010
(73) Patentinhaber: Robert Bosch GmbH, 70442 Stuttgart (DE)
(72) Erfinder: HERDEN, Werner, 70839 Gerlingen (DE); SCHMIDTKE, Bernd, 71229 Leonberg (DE)
(86) Internationale Anmeldenummer: PCT/EP2008/059608
(87) Internationale Veröffentlichungsnummer: WO 2009/037036

(56) Entgegenhaltungen:
- EP-A- 0 723 323
- WO-A-96/38749
- WO-A-97/42533
- DE-A1-102008 027 229
- JP-A- 8 271 763
- JP-A- 2001 296 448
- JP-A- 2002 277 688
- US-A- 4 106 847
- US-A- 5 204 927
- US-A- 5 268 978
- US-A1- 2004 105 482
- THOMAS GRAF ET AL.: "20 Jahre ganzheitliche Laserforschung für die Fertigungstechnik im IFSW", LASER TECHNIK JOURNAL, no. 5, November 2006 (2006-11), pages 8-14,
- "VDI-Richtlinie 2232-2004-01", January 2004 (2004-01), Verein Deutscher Ingenieure

## Beschreibung

### Stand der Technik

Aus der DE 10 2004 006 932 B2 ist ein Diodenlaser mit einer Einrichtung zur Strahlformung bekannt. Bei diesem Diodenlaser werden auf der Einkoppelseite die Enden der Lichtleitfasern so verformt, dass sie mit den benachbarten Lichtleitfasern verschmelzen und einen rechteckigen Querschnitt erhalten. Dadurch soll erreicht werden, dass das von den Emittern des Diodenlasers emittierte Laserlicht bestmöglich in die Lichtleitfasern eingekoppelt wird. Weitere Diodenlaser und/oder Einrichtungen zur Strahlformung sind aus der WO 96/38749, der US 5 268 978, der EP 0723 323 A2, der US 2004/015482 A1 und der US 5 204 927 bekannt

Der Erfindung liegt die Aufgabe zugrunde, einen Diodenlaser mit einer Einrichtung zur Strahlformung anzugeben, mit weiter verbesserter Einkopplung des von dem Diodenlaser emittierten Laserlichts und ein Verfahren zur Herstellung einer Strahlformungseinrichtung eines solchen Diodenlasers anzugeben.

### Offenbarung der Erfindung

Diese Aufgabe wird erfindungsgemäß durch die Merkmale des Anspruchs 1 gelöst. Durch die Verformung des Querschnitts der Fasern an ihren dem Diodenlaserbarren zugewandten Ende wird erreicht, dass der Querschnitt der Fasern dem Austrittsquerschnitt der Emitter des Diodenlaserbarrens angenähert wird und somit der Durchmesser der Fasern bei gleicher eingekoppelter Lichtleistung verkleinert werden kann. So kann beispielsweise durch ein Abflachen des ursprünglichen kreisrunden Querschnitts der Fasern auf die Hälfte bei entsprechender vergrößerter Breite der Faser eine Erhöhung der pro Fläche und Raumwinkel abgestrahlten Lichtleistung (Brightness) um den Faktor vier erreicht werden.

Eine Vorrichtung gemäß der Erfindung wird in Anspruch 1 und den Zugehörigen abhängigen Ansprüchen 2 - 4 definiert.

Infolgedessen können dünnere und somit kostengünstigere Lichtleiterfasern verwendet werden und die Formung des Lichts am Ausgang des Lichtleiters kann in besserer optischer Qualität erfolgen. Erfindungsgemäß ist vorgesehen, dass die Strahlformungseinrichtung mindestens ein optisches Element umfasst, welches stoffschlüssig mit den Lichtleitfasern verbunden ist. Bevorzugt wird dabei der Mantel der Lichtleitfasern im Bereich des optischen Elements entfernt, bevor das optische Element stoffschlüssig mit den Lichtleitfasern verbunden wird. Bevorzugt ist das optische Element aus Glas. Dadurch wird die Lichtleitungseigenschaft der Fasern auf der Einkoppelseite des Lichtleiters nicht durch den Brechzahlunterschied zwischen Faser-Kern und dem Mantel der Fasern, sondern zwischen dem Faser-Kern und dem optischen Element bestimmt. Dadurch ergeben sich weitere Freiheitsgrade bei der optischen Auslegung der Strahlformungseinrichtung. Insbesondere kann der Divergenzwinkel der in die Faser eingekoppelten Strahlung durch geeignete Glasauswahl und Formgebung des optischen Elements vergrößert werden, so dass eine weitere Optimierung der Einkoppelung des Laserlichts in den Lichtleiter ermöglicht wird. Durch eine geeignete Auswahl der Kombination der Glasqualitäten von optischem Element und Fasern besteht hier ein erhebliches Optimierungspotential.

Die eingangs genannte Aufgabe wird ebenfalls erfüllt durch ein Verfahren zum Herstellen einer Strahlformungseinrichtung eines Diodenlasers, bei welchem zunächst die Fasern eines Lichtleiters in einem Mittenabschnitt so ausgerichtet werden, dass mehrere Fasern in einer Ebene und parallel zueinander verlaufen. Anschließend werden die Fasern in dem Mittenabschnitt auf ihre Erweichungstemperatur erwärmt. In diesem Zustand werden die Fasern in dem Mittenabschnitt mit einem oder mehreren Formteilen gepresst, bis sie den gewünschten Querschnitt erreicht haben, und gleichzeitig stoffschlüssig mit den Formteilen verbunden. Die stoffschlüssige Verbindung kann auch durch nachträgliches Einzufügen eines geeigneten Klebstoffes erfolgen. Anschließend werden die Fasern in einer Trennebene, die durch den Mittenabschnitt und orthogonal zu den Fasern verläuft, aufgetrennt.

Durch das Auftrennen der Fasern entstehen zwei Enden von Lichtleitern mit erfindungsgemäß verformten Querschnitten der Fasern. Dies bedeutet, dass durch das einmalige Durchführen des erfindungsgemäßen Verfahrens zwei erfindungsgemäße Lichtleiter erzeugt werden können, wobei alle Verfahrensschritte nur einmal durchgeführt werden müssen. Daher zeichnet sich das erfindungsgemäße Verfahren durch eine hohe Effizienz und Wirtschaftlichkeit aus.

Außerdem ist es leichter, die Fasern in einem Mittenabschnitt, das heißt nicht an einem Ende des Lichtleiters parallel zueinander auszurichten, beziehungsweise zu führen, als wenn die Fasern an einem Ende des Lichtleiters ausgerichtet werden müssten.

In weiterer vorteilhafter Ausgestaltung der Erfindung des erfindungsgemäßen Verfahrens werden die Fasern nach dem Pressen unter ihre Erweichungstemperatur abgekühlt, so dass sie sich nicht mehr weiter verformen.

Es ist besonders vorteilhaft, wenn die Fasern so ausgerichtet werden, dass ihr lateraler Abstand dem Abstand der Emitter eines Diodenlaserbarrens in Richtung der slow-axis entspricht. Auf diese Weise wird zusammen mit der Durchführung des erfindungsgemäßen Verfahrens die spätere Zuordnung einer Faser zu einem Emitter des Diodenlaserbarrens mit der erforderlichen Genauigkeit erreicht. Dies ist insbesondere bei einer Serienfertigung von wirtschaftlichem Vorteil. Außerdem wird die Einkoppelung des von dem Diodenlaserbarren emittierten Lichts in den Lichtleiter verbessert und vereinfacht.

Eine weitere besondere vorteilhafte Ausgestaltung des erfindungsgemäßen Verfahren sieht vor, dass die Formteile im Bereich des Mittenabschnitts beim Pressen eine stoffschlüssige Verbindung mit den Fasern eingehen. Diese Formteile können bevorzugt aus Glas bestehen, wobei die den Fasern zugewandten Seiten der Formteile die gewünschte Form der Fasern des Lichtleiters aufweisen können, so dass die Formteile zunächst die gewünschte Verformung der Lichtleitfasern bewirken und nach erfolgter Verschmelzung mit den Fasern als optisches Element dienen.

Diese Formteile ermöglichen somit weitere Freiheitsgrade bei der Gestaltung der Einkoppeleinrichtung und ermöglichen aufgrund ihrer größeren Abmessungen und ihrer Robustheit eine vereinfachte Bearbeitung des Lichtleiters an der Einkoppelseite. Das optische Element kann aus einem opakem Material, wie zum Beispiel Metall, oder einem für die Laserstrahlen transmissiven Material, wie zum Beispiel Glas, bestehen. Wenn das optische Element aus Glas besteht, kann es geschliffen und poliert werden und in Form einer Zylinderlinse oder eines Prismas gestaltet werden.

Wenn oberhalb und unterhalb der Fasern jeweils ein Einlegeteil in das Formwerkzeug eingelegt wird, empfiehlt es sich, die Einlegeteile zusammen mit den Fasern zu trennen. Dies kann beispielsweise durch Sägen oder Schleifen erfolgen. Alternativ ist es auch möglich, dass oberhalb der Fasern und unterhalb der ausgerichteten Fasern jeweils zwei Einlegeteile eingelegt werden, wobei die Einlegeteile sich im Bereich einer Trennebene (C-C) berühren. Dadurch ist es möglich, bei dem Pressvorgang gleichzeitig die Fasern mit den Einlegeteilen stoffschlüssig zu verbinden und zu vermeiden, dass anschließend das gesamte optische Element wieder getrennt werden muss. In diesem Fall ist es dann lediglich nur noch erforderlich, die Fasern im Bereich der Trennebene zu trennen.

Es hat sich als vorteilhaft erwiesen, wenn der laterale Abstand der Fasern zueinander mittels V-Nuten, versenkten V-Nuten oder halbrunden Nuten eingestellt werden. Alternativ kann dies durch entsprechende Nuten in einem der Formteils oder einem Rahmen, der die Formteile umgibt erfolgen. Auf diese Weise kann ein "Verdrehen" oder ein "Überkreuzen" von Fasern im Bereich des Mittenabschnitts sicher und einfach vermieden werden.

Weitere Vorteile und vorteilhafte Ausgestaltungen der Erfindung sind der nachfolgenden Zeichnung, deren Beschreibung und den Patentansprüchen entnehmbar. Alle in der Zeichnung, deren Beschreibung und den Patentansprüchen offenbarten Merkmale können sowohl einzeln als auch in beliebiger Kombination miteinander erfindungswesentlich sein.

### Kurze Beschreibung der Zeichnungen

In der Zeichnung zeigt:
- Figur 1a: eine schematische Darstellung einer Brennkraftmaschine mit einer laserbasierten Zündeinrichtung;
- Figur 1b: eine schematische Darstellung der Zündeinrichtung aus Figur 1;
- Figur 2: eine schematische Draufsicht auf eine erfindungsgemäße Laserlichtquelle der Zündeinrichtung aus Figur 1b;
- Figuren 3 - 5: ein erstes Ausführungsbeispiel des erfindungsgemäßen Verfahrens in verschiedenen Stadien;
- Figuren 6 - 12: ein zweites Ausführungsbeispiel des erfindungsgemäßen Verfahrens in verschiedenen Stadien und
- Figur 13: verschiedene Ausführungsbeispiele von Nuten zur Ausrichtung der Fasern.

### Ausführungsformen der Erfindung

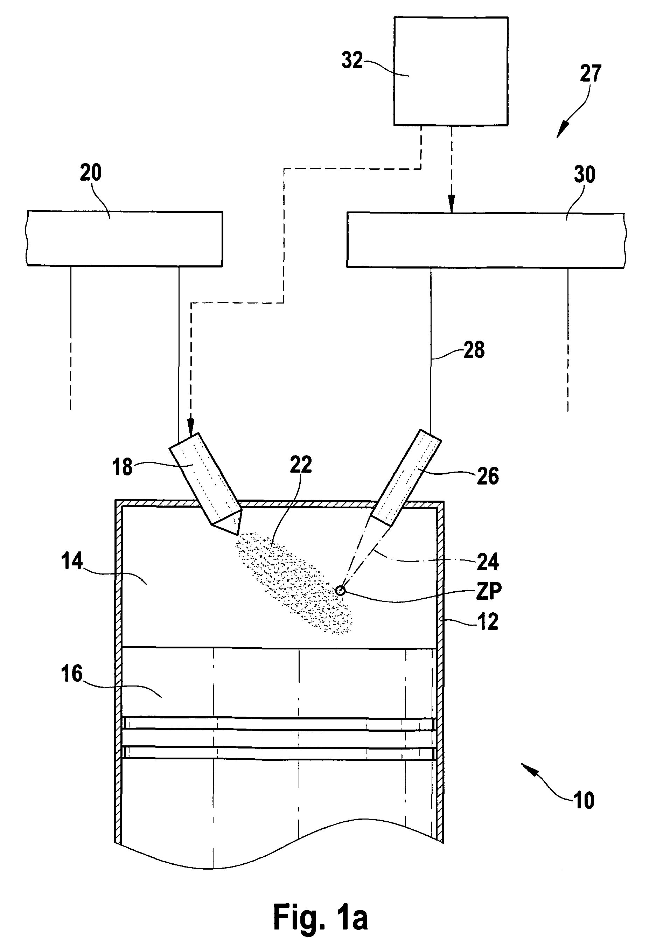

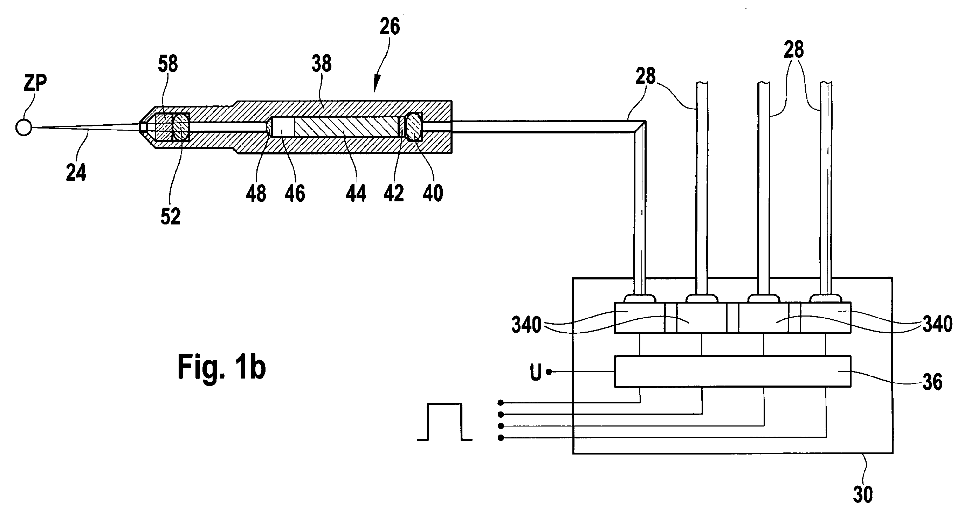

Eine Brennkraftmaschine trägt in Figur 1a insgesamt das Bezugszeichen 10. Sie kann zum Antrieb eines nicht dargestellten Kraftfahrzeugs dienen. Die Brennkraftmaschine 10 umfasst mehrere Zylinder, von denen in Figur 1 nur einer mit dem Bezugszeichen 12 bezeichnet ist. Ein Brennraum 14 des Zylinders 12 wird von einem Kolben 16 begrenzt. Kraftstoff gelangt in den Brennraum 14 direkt durch einen Injektor 18, der an einen auch als Rail bezeichneten Kraftstoff-Druckspeicher 20 angeschlossen ist.

In den Brennraum 14 eingespritzter Kraftstoff 22 wird mittels eines Laserimpulses 24 entzündet, der von einer eine Lasereinrichtung 26 umfassenden Zündeinrichtung 27 in den Brennraum 14 abgestrahlt wird. Hierzu wird die Lasereinrichtung 26 über eine Lichtleitereinrichtung 28 mit einem Pumplicht gespeist, welches von einer Pumplichtquelle 30 bereitgestellt wird. Die Pumplichtquelle 30 wird von einem Steuergerät 32 gesteuert, das auch den Injektor 18 ansteuert.

Wie aus Figur 1b hervorgeht, speist die Pumplichtquelle 30 mehrere Lichtleitereinrichtungen 28 für verschiedene Lasereinrichtungen 26, die jeweils einem Zylinder 12 der Brennkraftmaschine 10 zugeordnet sind. Hierzu weist die Pumplichtquelle 30 mehrere einzelne Laserlichtquellen 340 auf, die mit einer Pulsstromversorgung 36 verbunden sind. Durch das Vorhandensein der mehreren einzelnen Laserlichtquellen 340 ist gleichsam eine "ruhende" Verteilung von Pumplicht an die verschiedenen Lasereinrichtungen 26 realisiert, so dass keine optischen Verteiler oder dergleichen zwischen der Pumplichtquelle 30 und den Lasereinrichtungen 26 erforderlich sind.

Die Lasereinrichtung 26 weist beispielsweise einen laseraktiven Festkörper 44 mit einer passiven Güteschaltung 46 auf, die zusammen mit einem Einkoppelspiegel 42 und einem Auskoppelspiegel 48 einen optischen Resonator bildet. Unter Beaufschlagung mit von der Pumplichtquelle 30 erzeugtem Pumplicht erzeugt die Lasereinrichtung 26 in an sich bekannter Weise einen Laserimpuls 24, der durch eine Fokussieroptik 52 auf einen in dem Brennraum 14 (Figur 1a) befindlichen Zündpunkt ZP fokussiert ist. Die in dem Gehäuse 38 der Lasereinrichtung 26 vorhandenen Komponenten sind durch ein Brennraumfenster 58 von dem Brennraum 14 getrennt.

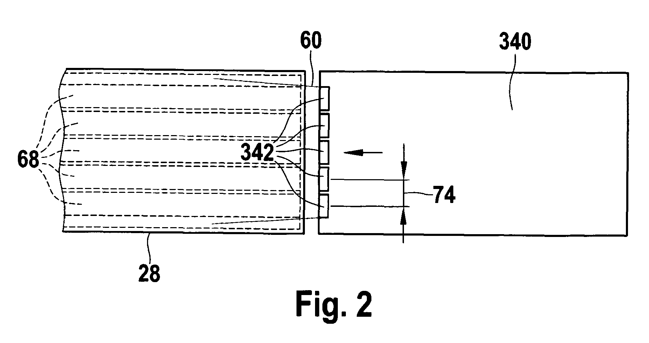

Figur 2 zeigt eine schematische Draufsicht auf eine erste Ausführungsform der erfindungsgemäßen Laserlichtquelle 340. Wie aus Figur 2 ersichtlich ist, weist die Laserlichtquelle 340 mehrere Laserlicht abstrahlende Emitter 342 auf, deren Laserlicht als Pumplicht 60 zum optischen Pumpen der Lasereinrichtung 26 (Figur 1b) bzw. des darin angeordneten laseraktiven Festkörpers 44 verwendet und dementsprechend in die Lichtleitereinrichtung 28 eingekoppelt wird. Der seitliche Abstand der Emitter 342 voneinander ist mit dem Bezugszeichen 74 versehen worden. Die Lichtleitereinrichtung 28 umfasst eine Vielzahl von Lichtleitfasern 68, die nachfolgend auch als Fasern 68 bezeichnet werden. Jeweils einem Emitter 342 ist bei dem in Figur 2 dargestellten Ausführungsbeispiel eine Lichtleitfaser 68 zugeordnet, um die Verluste bei der Einkopplung des von den Emittern 342 emittierten Pumplichts in die Lichtleitereinrichtung 28 zu minimieren.

Mit Hilfe der erfindungsgemäßen Verfahren kann die Zuordnung der Fasern 68 zu den Emittern 342 verbessert und gleichzeitig durch eine Verformung des Querschnitts der Fasern 68 an ihrem den Emittern 342 zugewandten Ende der Durchmesser der Fasern bei gleicher eingekoppelter Lichtleistung verkleinert werden. Dadurch werden Bauraum und Kosten eingespart.

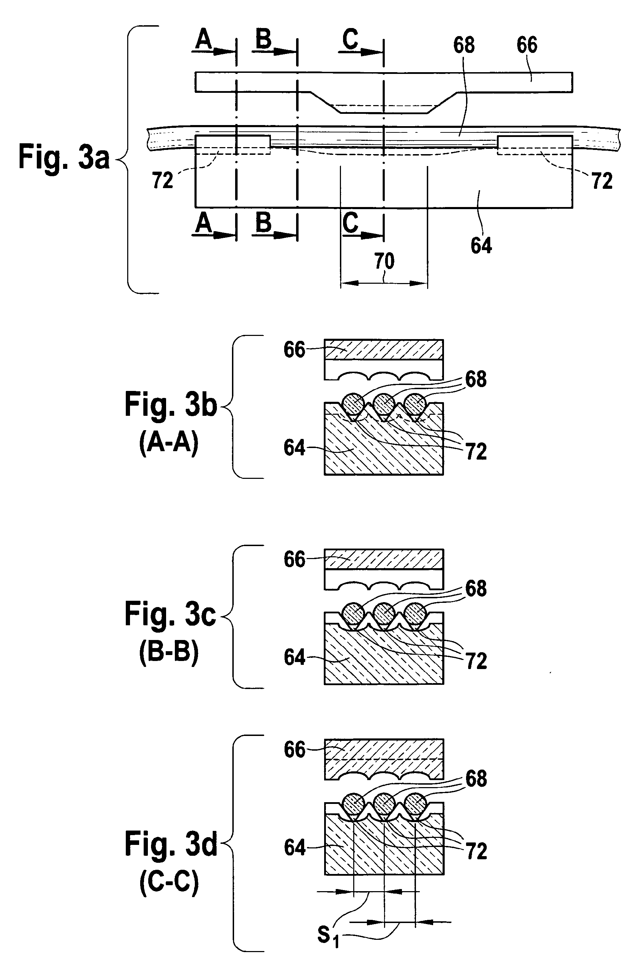

Anhand der Figuren 3 bis 5 wird nachfolgend ein erstes Ausfizhrungsbeispiel des erfindungsgemäßen Verfahrens beschrieben.

Ein Wesentlicher Aspekt des erfindungsgemäßen Verfahrens ist, dass die Fasern 68 nicht an ihrem Ende in die gewünschte Form und Lage gebracht werden, sondern, dass die Fasern 68 in einem Mittenabschnitt 70 in die gewünschte Form und Lage gebracht werden und anschließend in diesem Mittenabschnitt 70 aufgetrennt werden. Dadurch entstehen immer zwei nach dem erfindungsgemäßen Verfahren hergestellte Enden einer Lichtleitereinrichtung 28 auf einmal und gleichzeitig wird die Handhabung der Fasern 68 vereinfacht.

Die Anordnung der Fasern 68 in dem gewünschten seitlichen Abstand, der dem seitlichen Abstand 74 der Emitter 342 voneinander entspricht, und die Verformung des Querschnitts der Fasern 68 erfolgt mit Hilfe eines unteren Formteils 64 und eines oberen Formteils 66. Beide Formteile 64 und 66 werden durch das erfindungsgemäße Verfahren stoffschlüssig mit den Fasern 68 verbunden und bilden dann ein optisches Element, welches die Einkopplung des Pumplichts in die Lichtleitereinrichtung 28 ermöglicht, bzw. verbessert.

In der Figur 3a ist eine Seitenansicht des unteren Formteils 64 und des oberen Formteils 66 dargestellt. Die Formteile 64, 66 sind in Längsrichtung der Fasern 68 symmetrisch aufgebaut. Die Symmetrieebene C-C fällt in der Regel mit einer Trennebene, deren Bedeutung nachfolgend noch erläutert werden wird, zusammen.

Rechts und links der Trennebene C-C ist ein sogenannter Mittenabschnitt 70 der Formteile 64 und 66 vorhanden. Im Bereich des Mittenabschnitts 70 findet die gewünschte Verformung der Fasern 68 statt und verbinden sich die Formteile 64 und 66 stoffschlüssig mit den Fasern 68. Aus diesem Grund sind die Formteile 64 und 66 im Bereich des Mittenabschnitts "halbelliptisch" ausgebildet (siehe insbesondere Figur 3d).

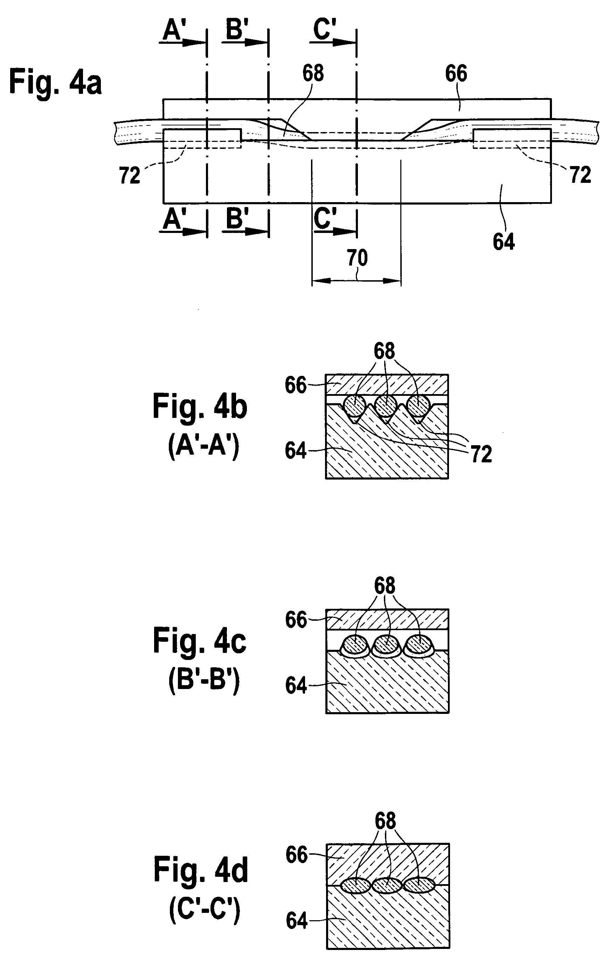

Rechts und links des Mittenabschnitts 70, dort wo die Schnittlinien A-A und B-B liegen, findet keine bleibende Verformung der Fasern 68 statt. Im Bereiche der Schnittlinien A-A werden die Fasern 68 in dem gewünschten Abstand zueinander ausgerichtet. Dies kann mit Hilfe von V-fönnigen Nuten 72 erfolgen (Siehe Schnitt A-A in Fig. 3b). Dabei entspricht der Abstand der Nuten 72 zueinander dem Abstand 74 der Emitter 342 zueinander (siehe Figur 2). Anschließend wird das obere Formteil 66 auf das untere Formteil 64 abgesenkt, wie dies in Figur 4a dargestellt ist. In Folge dessen nähert sich im Bereich der Schnittebenen A-A (siehe Figur 4b) das obere Formteil 66 so weit an das untere Fomiteil 64 an, dass die Fasern 68 in den Nuten 72 fixiert sind. Im Bereich des Schnitts B-B (siehe Figur 4c) werden die Fasern 68 auch bei abgesenktem oberen Formteil 66 nicht zwischen oberem Formteil 66 und unterem Formteil 64 geklemmt.

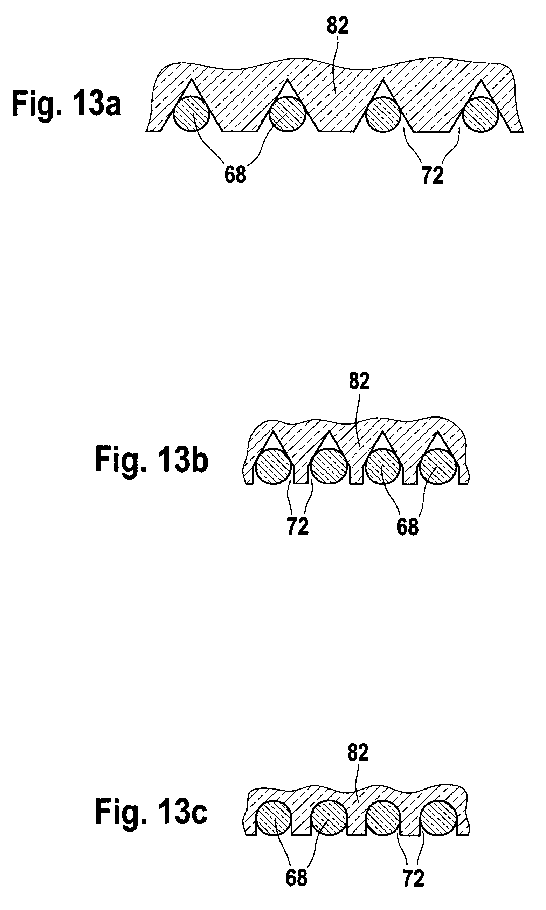

Wenn nun die Fasern 68 einer leichten Zugspannung ausgesetzt werden, ist gewährleistet die Fasern 68 auch im Mittenbereich 70 den gewünschten Abstand zueinander haben. Gleichzeitig werden die Fasern 68 im Mittenabschnitt bis auf ihre Erweichungstemperatur erwärmt. Die Faser-Ausrichtung kann auch durch eine geeignete Ausbildung der Nuten 72 erreicht werden. Besonders geeignete Formen von Nuten 72 sind in Figur 13 dargestellt.

Im Bereich des Mittenabschnitts 70 (Schnitt C-C) werden die Fasern 68 durch die Formteile 64, 66 so verformt, dass sie einen im Wesentlichen elliptischen Querschnitt annehmen. Dieser Querschnitt ist in dem Schnitt in Figur 4d dargestellt. Gleichzeitig mit der Verformung der Fasern 68 verbinden sich die Formteile 64 und 66 stoffschlüssig mit den Fasern 68 und bilden ein optisches Element. Zusätzlich kann die Verbindung nachträglich noch verklebt werden, wenn zum Beispiel ein UV-Kleber für Faseranwendungen eingesetzt wird, dringt der Kleber durch die Kapillarwirkung der Fasern in diese ein, so dass sich eine stabile Klebverbindung ausbildet. Die Formteile 64 und 66 können aus Glas hergestellt werden, wobei eine andere Glassorte als bei den Fasern 68 eingesetzt werden kann.

Ein lateraler Abstand S₁ zwischen den Fasern 68 ist in dem Schnitt C-C der Figur 3d dargestellt. Dieser laterale Abstand S₁, entspricht dem Abstand 74 der Emitter 342 (siehe Figur 2) voneinander. Dadurch werden die Fasern bezüglich ihres seitlich Abstands S₁ dauerhaft fixiert und es erfolgt die gewünschte Zuordnung der Fasern 68 zu einzelnen Emittern des Diodenlasers.

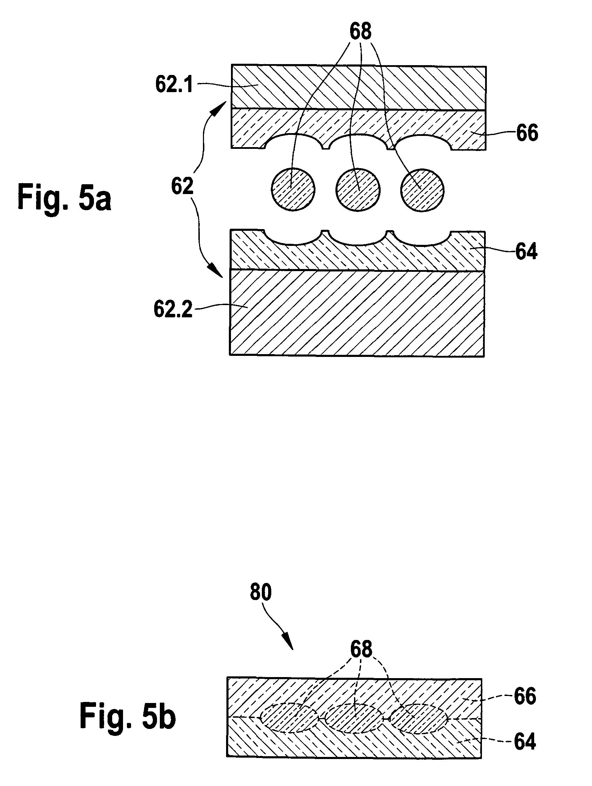

In Figur 5a ist die Anordnung der Formteile 64 und 66 in einem geöffneten Presswerkzeug 62.1 und 62.2 in der Trennebene C-C vergrößert dargestellt. Wie sich aus Figur 5a ergibt, haben die Formteile 64 und 66 auf ihren den Fasern 68 zugewandten Seiten halbelliptische Ausnehmungen (ohne Bezugszeichen), die zur Umformung und Aufnahme der Fasern 68 dienen.

Wenn nun das Formwerkzeug 62 geschlossen wird, nachdem mindestens die Fasern 68 auf ihre Erweichungstemperatur gebracht wurden, verformen die Formteile 64 und 66 die Fasern 68 plastisch. Gleichzeitig verbinden sich oberes Formteil 66, unteres Formteil 64 und die Fasern 68, so dass sich ein monolithischer Glaskörper ergibt. Aus diesem Glaskörper wird das optische Element 80 herausgearbeitet.

In Figur 5b ist ein solches optisches Element 80 im Schnitt dargestellt, wobei durch unterbrochene Linien die früheren Trennlinien zwischen Fasern 68, einem ersten Einlegeteil 76 und zweitem Einlegeteil 78 angedeutet sind.

Zusammenfassend lässt sich das erste Ausführungsbeispiel eines erfindungemäßen Verfahrens unter Bezugnahme auf die Figuren 3 bis 5 näher erläutern.

In einem ersten Schritt werden mehrere Fasern 68 nebeneinander ausgerichtet und in die Nuten 72 des unteren Formteils 64 eingelegt. Dies erfolgt zu beiden Seiten des Mittenabschnitts (siehe die Schnittebenen A-A in den Figuren 3b und 4b).

In einem Zwischenbereich (siehe die Schnittebenen B-B in den Figuren 3c und 4c) werden die Fasern von den Formteilen 64 und 66 nicht berührt, sondern die Fasern 68 befinden sich in dem Zwischenraum zwischen oberem Formteil 66 und unterem Formteil 64. Es kann hilfreich und vorteilhaft sein, wenn die Fasern 68 nach dem Ausrichten etwas unter Zugspannung gehalten werden, so dass die Fasern 68 im Bereich des Mittenabschnitts 70 nicht durchhängen und einen geradlinigen Verlauf haben.

In einem nächsten Schritt werden nun die Fasern 68 vor allem im Bereich des Mittenabschnitts 70 erwärmt. Dies kann zum Beispiel durch Infrarotstrahlen erfolgen. Alternativ können das obere Formteil 66 und/oder das untere Formteil 64 lokal beheizt und auf diese Weise die erforderliche Wärme bereitgestellt werden. Dabei erreichen die Fasern 68 mindestens ihre Erweichungstemperatur, so dass sie leicht umformbar sind, ohne zu brechen.

Sobald die Fasern 68 im Bereich des Mittenabschnitts 70 die Erweichungstemperatur erreicht haben, wird das Presswerkzeug 62 geschlossen und somit das obere Formteil 66 auf das untere Formteil 64 abgesenkt. Dabei kann gleichzeitig Kraft und Wärme von den Formteilen 64, 66 auf die Lichtleitfasern 68 übertragen werden. Außerdem verbinden sich die Formteile 64 und 66 und die Lichtleitfasern 68 stoffschlüssig miteinander. Alternativ oder zusätzlich können die Formteile 64 und 66 und die Lichtleitfasern 68 auch miteinander verklebt werden.

Anschließend werden die Lichtleitfasern 68 soweit abgekühlt, dass sie sich nicht mehr plastisch verformen lassen. Nun werden die Fasern 68 im Bereich der Symmetric- und Trennebene C-C zusammen mit den Formteilen 64 und 66 durchtrennt, so dass anschließend zwei Stücke eines Lichtleiters 28 vorhanden sind, bei denen jeweils ein Ende der Fasern 68 entsprechend dem erfindungsgemäßen Verfahren elliptisch verformt sind. Die beim Trennen entstehende Trennfläche wird nun in die gewünschte Form gebracht und poliert und falls erforderlich beschichtet. Als besonders geeignet hat es sich erwiesen, wenn die Formteile 64 und/oder 66 aus Glas hergestellt werden, wobei der Schmelzpunkt der Formteile 64 und 66 höher als der Schmelzpunkt der Lichtleitfasern 68 liegt.

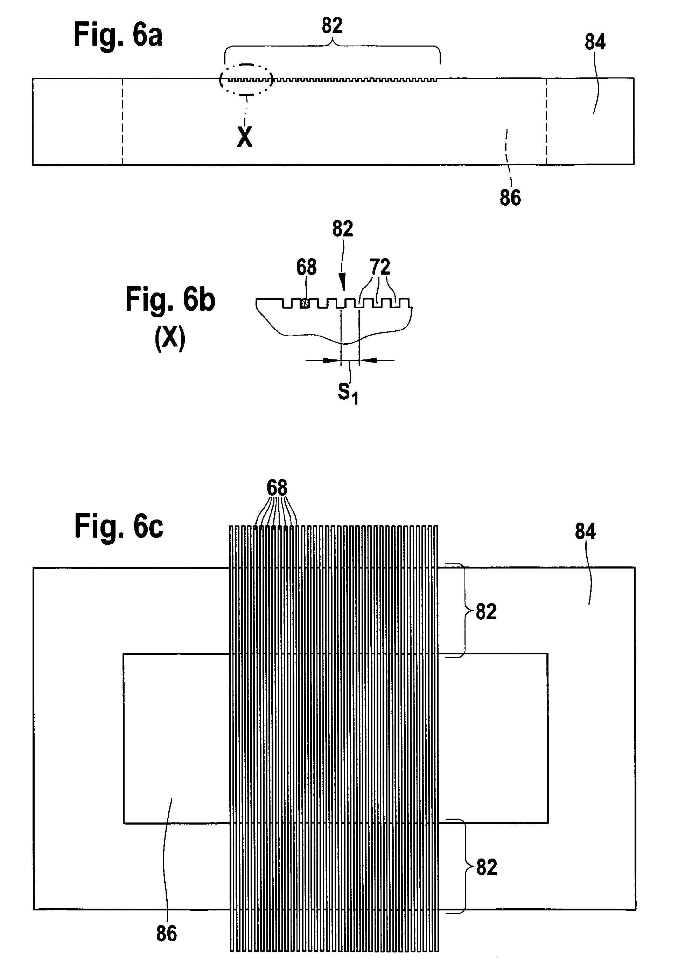

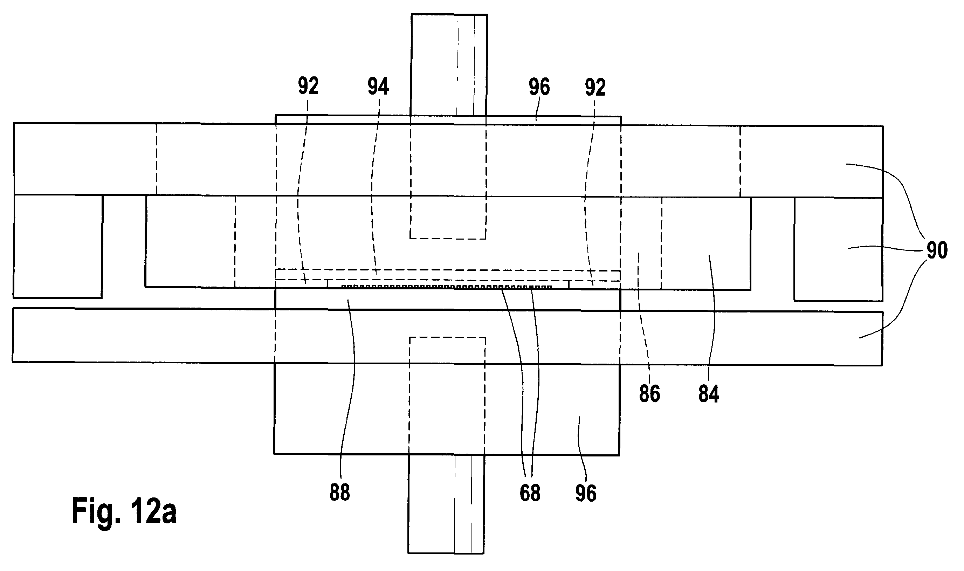

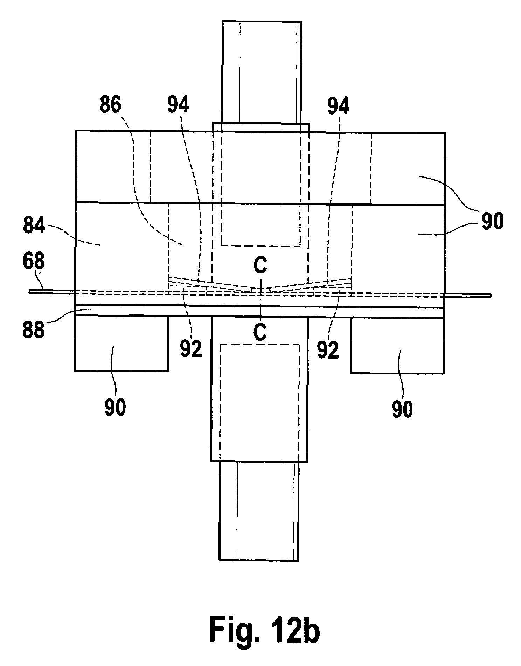

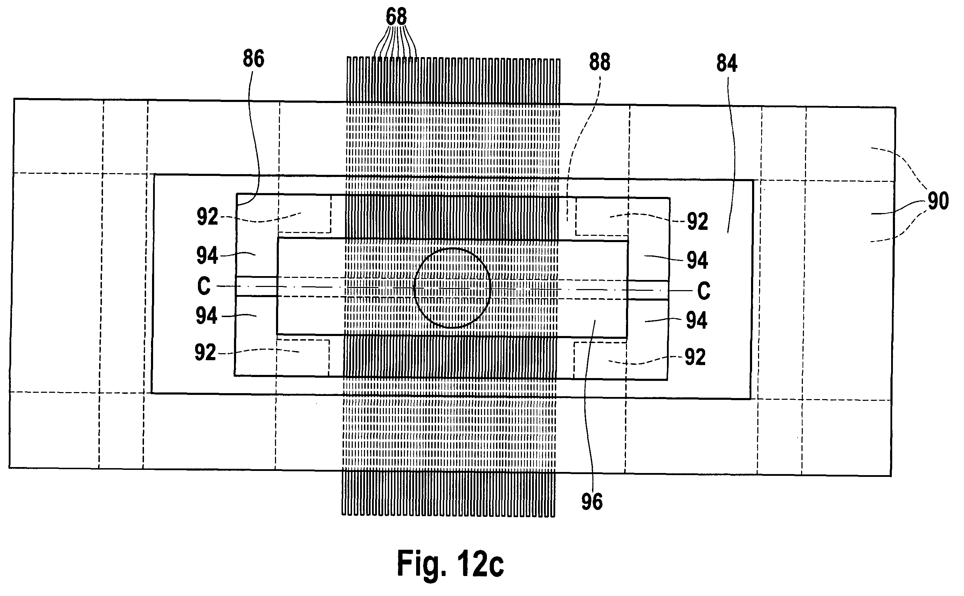

Anhand der Figuren 6 bis 12 wird nachfolgend ein weiteres Ausführungsbeispiel eines erfindungsgemäßen Verfahrens erläutert. Gleiche Bauteile werden mit gleichen Bezugszeichen versehen und es gilt das bezüglich der Figuren 1 bis 5 Gesagte entsprechend.

Bei dem Ausführungsbeispielen gemäß Figuren 6 ff erfolgt die Ausrichtung der Fasern 68 mit Hilfe von Kämmen 82. Diese Kämme 82 bestehen aus einer Vielzahl parallel zueinander verlaufender Nuten 72. Die Kämme 82 sind in einem Rahmen 84 zu beiden Seiten einer rechteckigen Aussparung 86 angeordnet. In der Draufsicht auf den Rahmen 84 sind die Aussparung 86 und die von den Kämmen 82 parallel zueinander ausgerichteten Fasern 68 gut zu erkennen.

In der Figur 6a sind die Kämme 82 ohne Fasern 68 dargestellte, während in dem zugehörigen Detail X (siehe Figur 6b) zur Veranschaulichung eine Faser 68 und der seitliche Abstand S₁ eingezeichnet ist.

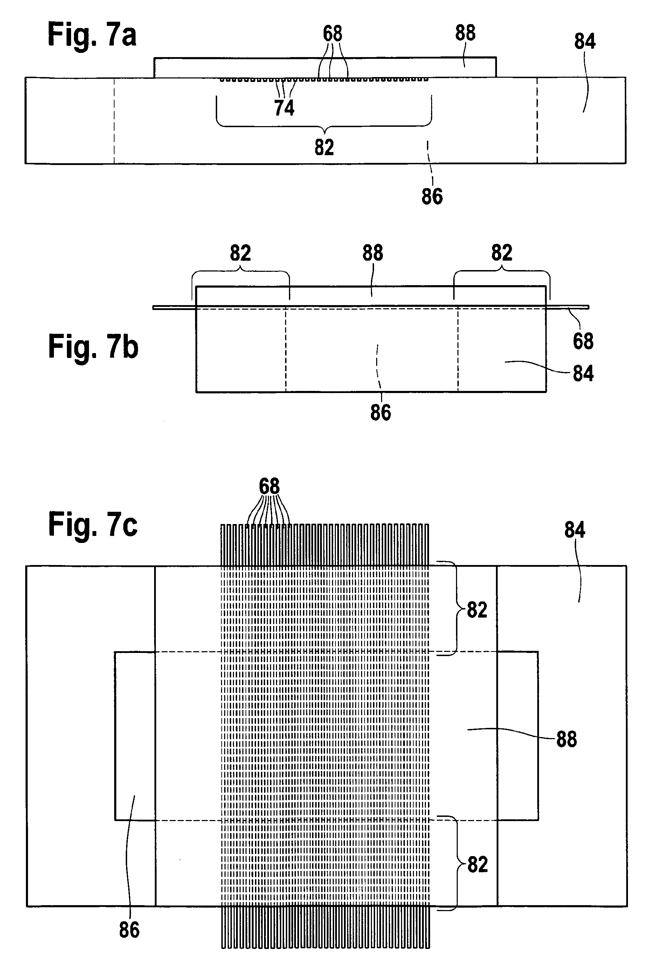

In einem weiteren Schritt wird ein erstes Glasplättchen 88 auf den Rahmen 84 und die auf dem Rahmen 84 liegenden Fasern 68 aufgelegt (siehe Figur 7). Das erste Glasplättchen 88 erstreckt sich über den Rahmen 84 in Richtung der Fasern 68 und hält die Fasern 68 in den Nuten 72.

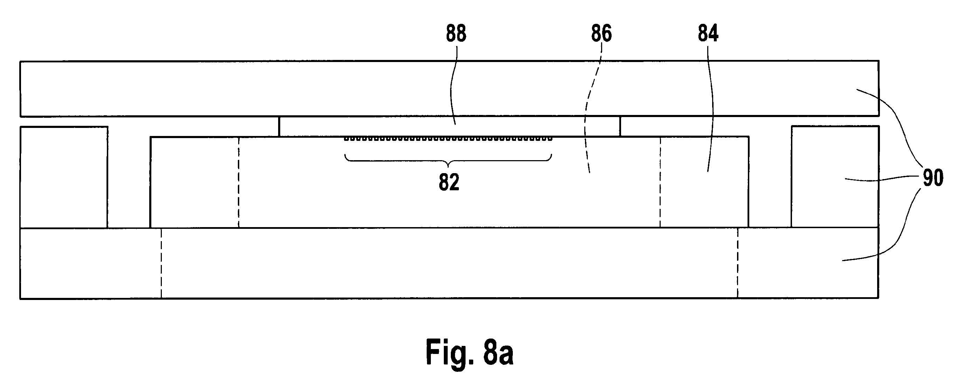

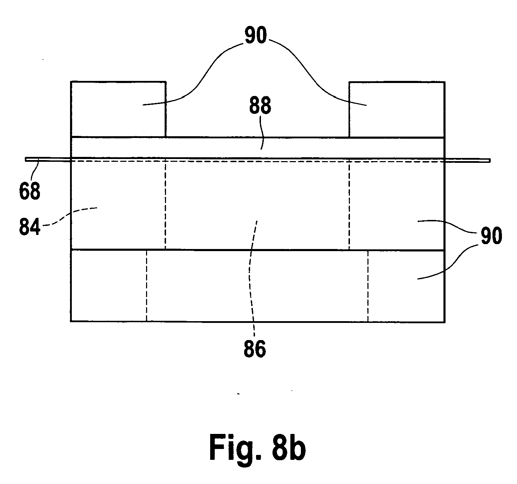

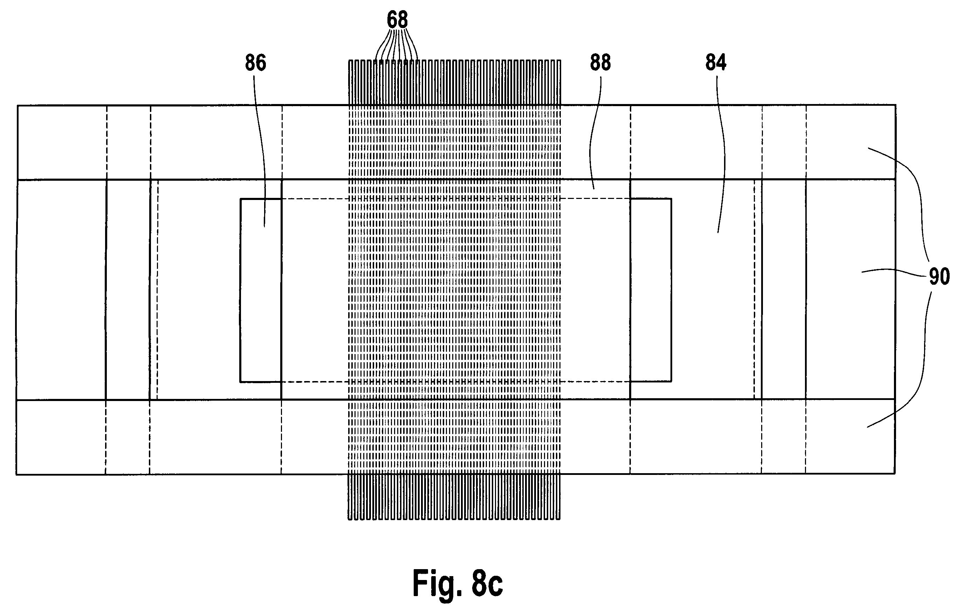

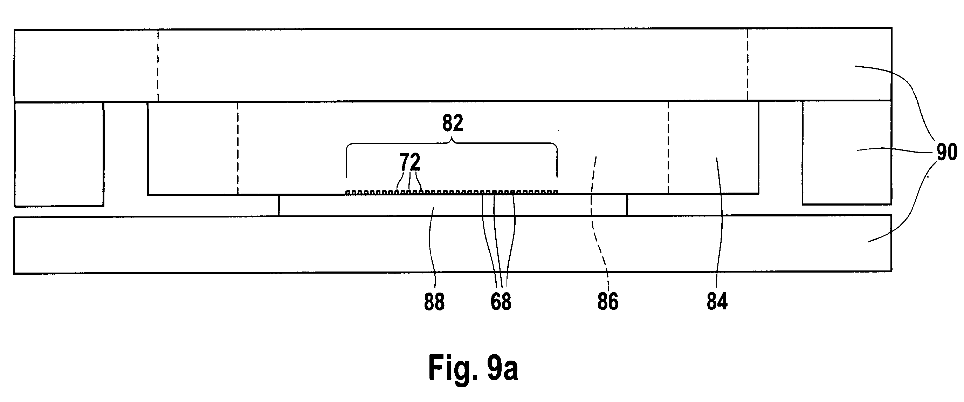

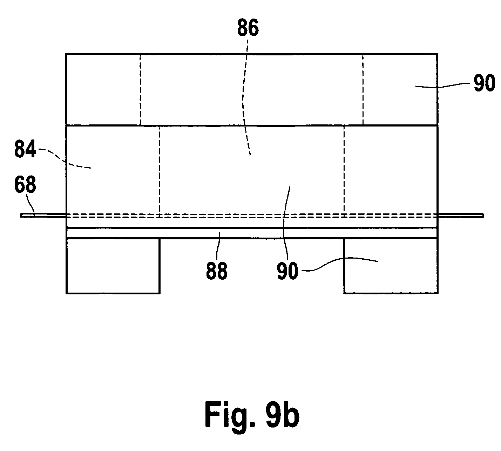

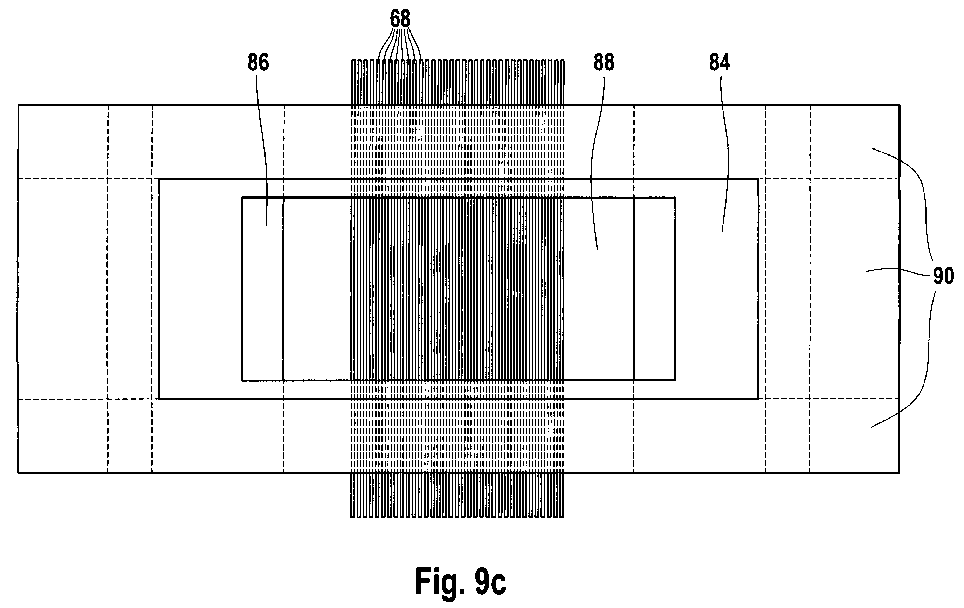

In einem weiteren Schritt, der in Figur 8 dargestellt ist, werden Rahmen 84, Fasern 68 und das erste Glasplättchen 88 von mehreren Halteelementen 90 relativ zueinander fixiert und die Oberseite nach unten gedreht (siehe Figur 9).

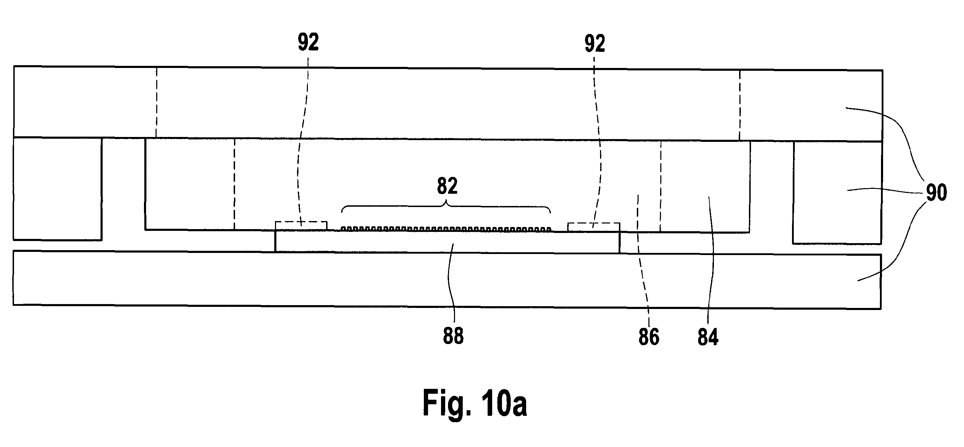

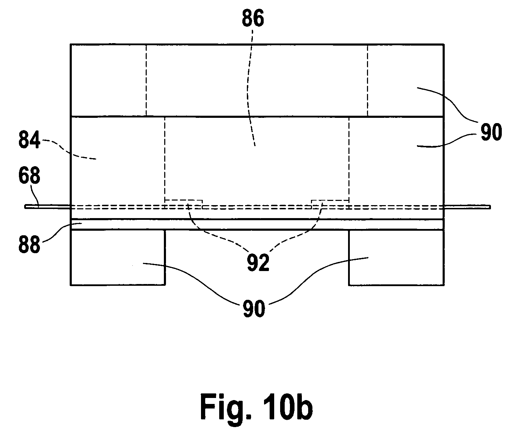

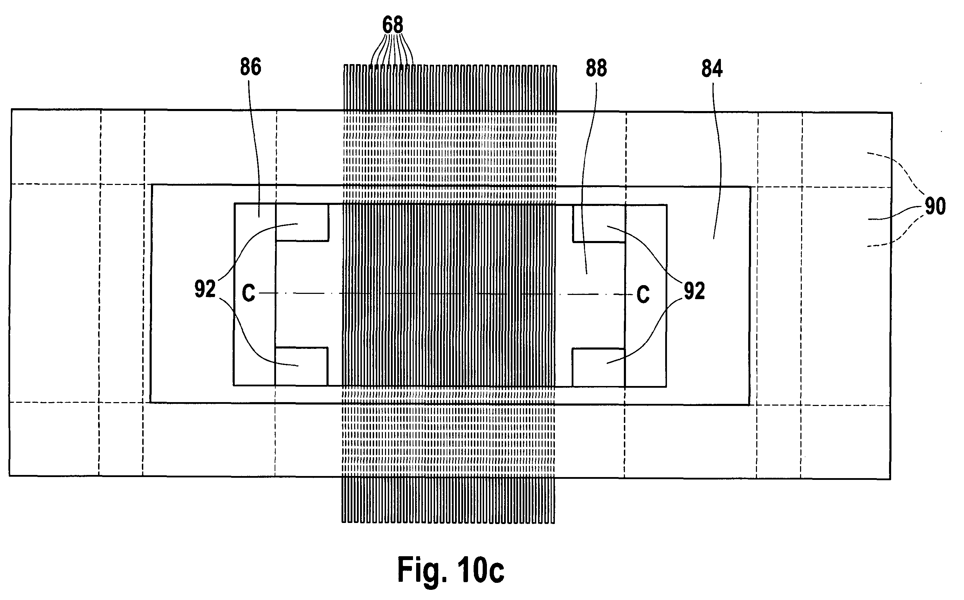

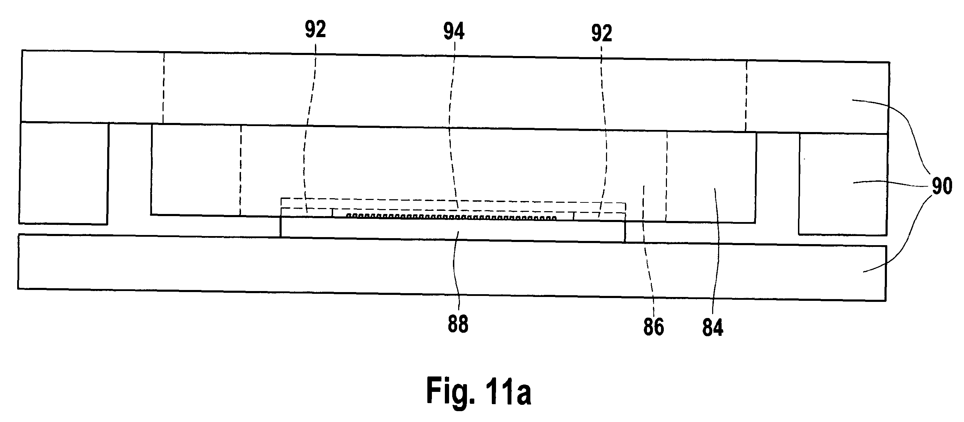

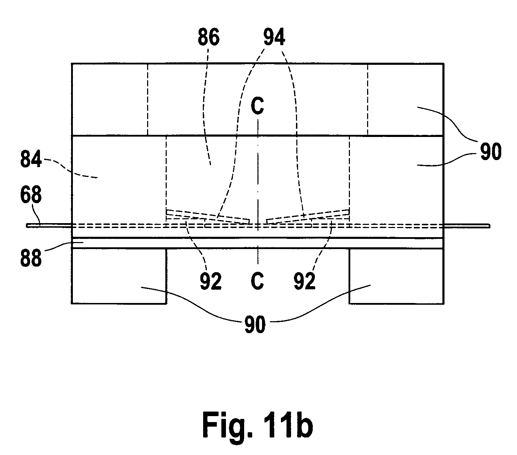

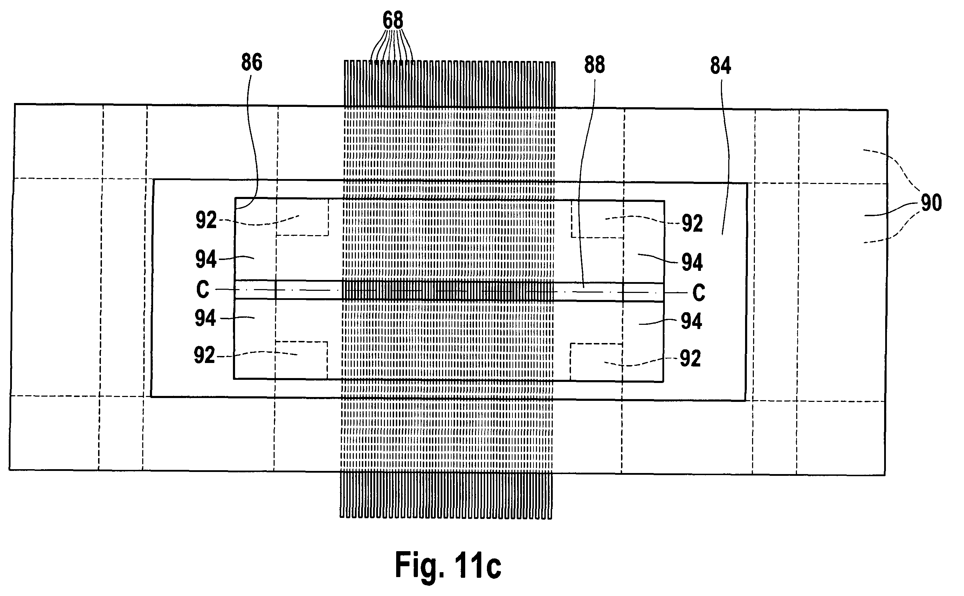

Wie aus Figur 10 ersichtlich, werden daraufhin rechts und links der Fasern 68 und in einem gewissen Abstand zu der Trennebene C-C insgesamt 4 Unterlegplättchen 92 auf das erste Glasplättchen 88 aufgelegt. In dem darauf folgenden Schritt wird rechts und links der Trennebene C-C jeweils ein zweites Glasplättchen 94 auf die Unterlegplättchen 92 und das erste Glasplättchen 88 aufgelegt. Diese Konstellation ist in einer Seitenansicht links unten in Figur 11 dargestellt. Die Unterlegplättchen 92 dienen dazu, eine Schrägstellung der zweiten Glasplättchen 94 relativ zur dem ersten Glasplättchen 88 zu erreichen.

Anschließend werden erstes Glasplättchen 88, Fasern 68 und zweite Glasplättchen 94 mit Hilfe von Stempeln 96 und unter Wärmezufuhr miteinander vepresst. Dabei findet vor allem im Bereich der Trennebene C-C die gewünschte Verformung der Fasern 68 und die stoffschlüssige Verbindung von erstem Glasplättchen 88, Fasern 68 und zweiten Glasplättchen 94 statt. Wegen der Schrägstellung der zweiten Glasplättchen 94 nehmen die Fasern 68 mit zunehmendem Abstand von der Trennebene C-C wieder einen kreisförmigen der Querschnitt an.

Schließlich werden nach dem Abkühlen die Fasern 68 und das erste Glasplättchen 88 entlang der Trennebene C-C getrennt und die Schnittflächen geschliffen und poliert, so dass ein optisches Element 80 gebildet wird.

Vorteilhaft an dem zweiten Ausführungsbeispiel des erfindungsgemäßen Verfahrens ist, das die benötigten hoch präzise gefertigten, strukturierten Komponenten nur als Werkzeug eingesetzt werden und in Folge dessen mehrfach verwendet werden können.

In Figur 13 sind verschiedene Ausführungsbeispiele von Nuten 72 angedeutet. In Figur 13a sind mehrere V-Nuten im Schnitt dargestellt. In Figur 13b sind "versenkte" V-Nuten 72 dargestellt und bei dem Ausführungsbeispiel gemäß Figur 13c ist der Grund der Nuten 72 halbrund ausgebildet.

## Patentansprüche

1. Diodenlaser (340), mit mindestens einem Diodenlaserbarren (31), wobei der Diodenlaserbarren (31) eine Vielzahl von Emittern (342) aufweist, wobei die Emitter (342) in Richtung ihrer Längsachse nebeneinander angeordnet sind, und mit einer dem Diodenlaserbarren (31) zugeordneten Strahlformungseinrichtung für den aus dem Diodenlaserbarren (31) austretenden Laserstrahl (24), wobei die Strahlformungseinrichtung eine Lichtleitereinrichtung (28) mit mehreren Fasern (68) umfasst in welche der Laserstrahl eingekoppelt wird, wobei eine maximale Dicke (D) der Lichtleitfasern (68) an ihrem dem Diodenlaserbarren (31) zugewandten Ende deutlich kleiner als deren Breite (B) ist, wobei die Strahlformungseinrichtung mindestens ein optisches Element (80) umfasst, welches stoffschlüssig mit den Lichtleitfasern (68) verbunden ist, **dadurch gekennzeichnet, dass** das optische Element mit den Lichtleitfasern (68) verschmolzen ist.

2. Diodenlaser (340) nach Anspruch 1, **dadurch gekennzeichnet, dass** die Lichtleitfasern (68) an ihren dem Diodenlaserbarren (31) zugewandten Enden einen angenähert elliptischen Querschnitt aufweisen.

3. Diodenlaser (340) nach Anspruch 1 oder 2, **dadurch gekennzeichnet, dass** das optische Element (80) aus Glas ist.

4. Diodenlaser (340) nach Anspruch 3, **dadurch gekennzeichnet, dass** ein Kern der Lichtleitfasern (68) direkt mit dem optischen Element (80) der Strahlformungseinrichtungverbunden ist.

5. Verfahren zur Herstellung einer Strahlformungseinrichtung eines Diodenlasers (340) mit den folgenden Verfahrensschritten:
Ausrichten der Fasern (68) einer Lichtleitereinrichtung (28) in einem Mittenabschnitt (70), so dass mehrere Fasern (68) in einer Ebene und parallel zueinander verlaufen,
Erwärmen der Fasern (68) in dem Mittenabschnitt (70) bis sie ihre Erweichungstemperatur erreicht haben,
Pressen der Fasern (68) in dem Mittenabschnitt (70) mit einem oder mehreren Formteilen (64, 66, 88, 92, 94) bis ihre Breite (B) größer als ihre maximale Dicke (D) ist, und
Trennen der Fasern (68) in einer Trennebene (C-C), wobei die Trennebene (C-C) in dem Mittenabschnitt (70) liegt und orthogonal zur Längsrichtung der Fasern (68) im Mittenabschnitt (70) verläuft.

6. Verfahren nach Anspruch 5, **dadurch gekennzeichnet, dass** ein Mantel der Fasern (68) vor dem Pressen der Fasern (68) entfernt wird.

7. Verfahren nach Anspruch 5 oder 6, **dadurch gekennzeichnet, dass** die Fasern (68) nach dem Pressen unter ihre Erweichungstemperatur abgekühlt werden.

8. Verfahren nach Anspruch 5 bis 7, dadurch gekennzeiclnet, dass die Fasern (68) so ausgerichtet werden, dass ihr lateraler Abstand (S₁) dem Abstand (74) der Emitter (342) eines Diodenlaserbarrens (31) in seiner Längsrichtung (fast-axis) entspricht.

9. Verfahren nach einem der Ansprüche 5 bis 8, **dadurch gekennzeichnet, dass** das oder die Formteile (64, 66, 88, 92, 94) beim Pressen eine stoffschlüssige Verbindung mit den Fasern (68) eingehen.

10. Verfahren nach Anspruch 9, **dadurch gekennzeichnet, dass** das oder die Formteile (64, 66, 88, 94) das optische Element (80) der Strahlformungseinrichtung bilden.

11. Verfahren nach einem der Ansprüche 5 bis 10, **dadurch gekennzeichnet, dass** das oder die Formteile (64, 66, 88, 94) zusammen mit den Fasern (68) in der Trennebene (C-C) getrennt werden.

12. Verfahren nach einem der Ansprüche 9 bis 11, **dadurch gekennzeichnet, dass** das oder die Formteile (94) in der Trennebene (C-C) geteilt sind.

13. Verfahren nach einem der Ansprüche 5 bis 12, **dadurch gekennzeichnet, dass** der laterale Abstand der Fasern (68) zueinander mittels Nuten (72), insbesondere V-Nuten, in einem der Formteile (64) eingestellt wird.

14. Verfahren nach einem der Ansprüche 5 bis 12, **dadurch gekennzeichnet, dass** der laterale Abstand der Fasern (68) zueinander mittels Nuten (72), insbesondere V-Nuten, in einem Rahmen (84) eingestellt wird.

## Claims

1. Diode laser (340), comprising at least one diode laser bar (31), wherein the diode laser bar (31) has a multiplicity of emitters (342), wherein the emitters (342) are arranged alongside one another in the direction of their longitudinal axis, and comprising a beam shaping device - assigned to the diode laser bar (31) - for the laser beam (24) emerging from the diode laser bar (31), wherein the beam shaping device comprises an optical waveguide device (28) having a plurality of fibres (68) into which the laser beam is coupled, wherein a maximum thickness (D) of the optical fibres (68) at their end facing the diode laser bar (31) is significantly smaller than their width (B), wherein the beam shaping device comprises at least one optical element (80) which is cohesively connected to the optical fibres (68), **characterized in that** the optical element is fused with the optical fibres (68).

2. Diode laser (340) according to Claim 1, **characterized in that** the optical fibres (68) have an approximately elliptical cross section at their ends facing the diode laser bar (31).

3. Diode laser (340) according to Claim 1 or 2, **characterized in that** the optical element (80) is composed of glass.

4. Diode laser (340) according to Claim 3, **characterized in that** a core of the optical fibres (68) is directly connected to the optical element (80) of the beam shaping device.

5. Method for producing a beam shaping device of a diode laser (340) comprising the following method steps:
aligning the fibres (68) of an optical device (28) in a central section (70), such that a plurality of fibres (68) run in one plane and parallel to one another,
heating the fibres (68) in the central section (70) until they have reached their softening temperature,
pressing the fibres (68) in the central section (70) using one or a plurality of shaped parts (64, 66, 88, 92, 94) until their width (B) is greater than their maximum thickness (D), and
separating the fibres (68) in a separating plane (C-C), wherein the separating plane (C-C) lies in the central section (70) and extends orthogonally with respect to the longitudinal direction of the fibres (68) in the central section (70).

6. Method according to Claim 5, **characterized in that** a cladding of the fibres (68) is removed before the fibres (68) are pressed.

7. Method according to Claim 5 or 6, **characterized in that** the fibres (68) are cooled below their softening temperature after pressing.

8. Method according to Claims 5 to 7, **characterized in that** the fibres (68) are aligned in such a way that their lateral distance (S₁) corresponds to the distance (74) between the emitters (342) of a diode laser bar (31) in its longitudinal direction (fast-axis).

9. Method according to any of Claims 5 to 8, **characterized in that** the shaped part or parts (64, 66, 88, 92, 94) become cohesively connected to the fibres (68) during pressing.

10. Method according to Claim 9, **characterized in that** the shaped part or parts (64, 66, 88, 94) form the optical element (80) of the beam shaping device.

11. Method according to any of Claims 5 to 10, **characterized in that** the shaped part or parts (64, 66, 88, 94) are separated together with the fibres (68) in the separating plane (C-C).

12. Method according to any of Claims 9 to 11, **characterized in that** the shaped part or parts (94) are split in the separating plane (C-C).

13. Method according to any of Claims 5 to 12, **characterized in that** the lateral distance between the fibres (68) is set by means of grooves (72), in particular V-grooves, in one of the shaped parts (64).

14. Method according to any of Claims 5 to 12, **characterized in that** the lateral distance between the fibres (68) is set by means of grooves (72), in particular V-grooves, in a frame (84).

## Revendications

1. Laser (340) à diodes qui présente au moins une barre (31) de laser à diodes, la barre (31) de laser à diodes présentant plusieurs émetteurs (342), les émetteurs (342) étant disposés les uns à côté des autres dans le sens de l'axe longitudinal, le laser à diodes présentant un dispositif de formation de faisceau associé à la barre (31) de laser à diodes pour le faisceau laser (24) qui sort de la barre (31) de laser à diodes,
le dispositif de formation de faisceau comprenant un dispositif (28) de guide de lumière présentant plusieurs fibres (68) dans lequel le faisceau laser est injecté, l'épaisseur maximale (D) des fibres (68) conductrices de lumière sur leur extrémité tournée vers la barre (31) de laser à diodes étant nettement plus petite que leur largeur (B), le dispositif de formation de faisceau comportant au moins un élément optique (80) relié en correspondance de matière aux fibres (68) conductrices de lumière,
**caractérisé en ce que**
l'élément optique est fusionné avec les fibres (68) conductrices de lumière.

2. Laser (340) à diodes selon la revendication 1, **caractérisé en ce que** les fibres (68) conductrices de lumière présentent une section transversale approximativement elliptique à leur extrémité tournée vers la barre (31) de laser à diodes.

3. Laser (340) à diodes selon la revendication 1 ou 2, **caractérisé en ce que** l'élément optique (80) est en verre.

4. Laser (340) à diodes selon la revendication 3, **caractérisé en ce que** l'âme des fibres (68) conductrices de lumière est reliée directement à l'élément optique (80) du dispositif de formation de faisceau.

5. Procédé de fabrication d'un dispositif de formation de faisceau d'un laser (340) à diodes, le procédé comportant les étapes suivantes :
aligner les fibres (68) d'un dispositif (28) de guide de lumière dans une partie centrale (70) de telle sorte que plusieurs fibres (68) s'étendent dans un plan et parallèlement les unes aux autres,
chauffer les fibres (68) dans la partie centrale (70) jusqu'à ce qu'elles aient atteint leur température d'amollissement,
comprimer les fibres (68) dans la partie centrale (70) à l'aide d'une ou plusieurs parties de moule (64, 66, 88, 92, 94) jusqu'à ce que leur largeur (B) soit supérieure à leur épaisseur maximale (D) et
séparer les fibres (68) dans un plan de séparation (C-C), le plan de séparation (C-C) étant situé dans la partie centrale (70) et s'étendant perpendiculairement au sens de la longueur des fibres (68) dans la partie centrale (70).

6. Procédé selon la revendication 5, **caractérisé en ce que** l'enveloppe des fibres (68) est enlevée avant la compression des fibres (68).

7. Procédé selon la revendication 5 ou 6, **caractérisé en ce que** les fibres (68) sont refroidies en dessous de leur température d'amollissement après la compression.

8. Procédé selon les revendications 5 à 7, **caractérisé en ce que** les fibres (68) sont alignées de telle sorte que leur distance latérale (S₁) corresponde à la distance (74) entre les émetteurs (342) d'une barre (31) de laser à diodes dans le sens de sa longueur (axe fast).

9. Procédé selon l'une des revendications 5 à 8, **caractérisé en ce que** la ou les parties de moule (64, 66, 88, 92, 94) s'engagent dans une liaison en correspondance de matière avec les fibres (68) lors de la compression.

10. Procédé selon la revendication 9, **caractérisé en ce que** la ou les pièces de moule (64, 66, 88, 94) forment l'élément optique (80) du dispositif de formation de faisceau.

11. Procédé selon l'une des revendications 5 à 10, **caractérisé en ce que** la ou les pièces de moule (64, 66, 88, 94) sont séparées avec les fibres (68) dans le plan de séparation (C-C).

12. Procédé selon l'une des revendications 9 à 11, **caractérisé en ce que** la ou les pièces de moule (94) sont divisées dans le plan de séparation (C-C).

13. Procédé selon l'une des revendications 5 à 12, **caractérisé en ce que** la distance latérale entre les fibres (68) est ajustée au moyen de rainures (72) et en particulier de rainures en V ménagées dans l'une des pièces de moule (64).

14. Procédé selon l'une des revendications 5 à 12, **caractérisé en ce que** la distance latérale entre les fibres (68) est ajustée dans un cadre (84) au moyen de rainures (72) et en particulier de rainures en V.
